# EUROPÄISCHE PATENTSCHRIFT

(11) **EP 1 095 547 B1**
(45) Veröffentlichungstag und Bekanntmachung des Hinweises auf die Patenterteilung: **02.05.2003**
(21) Anmeldenummer: 99932856.0
(22) Anmeldetag: 08.07.1999
(51) Int. Cl.: H05K 7/20

(54) **FADENBEARBEITUNGSSYSTEM**
YARN TREATMENT SYSTEM
SYSTEME DE TRAITEMENT DE FIL

(30) Priorität: 08.07.1998 DE 19830576
(43) Veröffentlichungstag der Anmeldung: 02.05.2001
(73) Patentinhaber: IROPA AG, 6340 Baar (CH)
(72) Erfinder: BIRGER, Johansson, S-523 33 Ulricehamn (SE)
(74) Vertreter: Bertram, Rainer
(86) Internationale Anmeldenummer: EP9904820
(87) Internationale Veröffentlichungsnummer: WO00003575

(56) Entgegenhaltungen:
- EP-A- 0 116 396
- DE-A- 2 651 857
- US-A- 5 812 375

## Beschreibung

Die Erfindung betrifft eine Fadenbearbeitungsvorrichtung gemäß Oberbegriff des Patentanspruchs 1.

Fadenbearbeitungsvorrichtungen, auf die sich die Erfindung bezieht, könnten nicht nur Fadenliefergeräte, sondern beispielsweise auch Zubehörvorrichtungen zur Fadenbearbeitung sein, die Textilmaschinen wie Web- oder Strickmaschinen, mit Faden versorgen, die wenigstens eine elektrisch angetriebene Komponente und eine dieser zugeordnete Steuerschaltung aufweisen. Neben Fadenliefergeräten können dies Fadenimprägnierer bzw. Fadenöler, gesteuerte Fadenbremsen und Fadenspanner, Fadenschlupfförderer, Drehantriebe für Faden-Vorratsspulen, und dgl. sein. Die Steuerschaltung kann sich dabei im Gehäuse des Fadenliefergeräts bzw. der Zubehörvorrichtung befinden, oder in einem eigenen Gehäuse des Fadenliefergeräts bzw. der Zubehörvorrichtung befinden, oder in einem eigenen Gehäuse das dennoch als Teil des Fadenbearbeitungsvorrichtung anzusehen ist.

Bei einem aus DE-C-265 18 57 bekannten Fadenliefergerät weist die Steuerschaltung des Antriebsmotors als Halbleiterkomponente Effekttransistoren auf. Die Steuerschaltung ist üblicherweise im Gehäuse angeordnet, wobei die Effekttransistoren auf der Leiterplatte positioniert sind. Im Betrieb erzeugen die Halbleiterkomponenten Wärme, die bei längerem Betrieb zu einem relativ hohen Wärmeniveau führt, das die Standzeit der Steuerschaltung, insbesondere der Halbleiterkomponenten, beeinträchtigt.

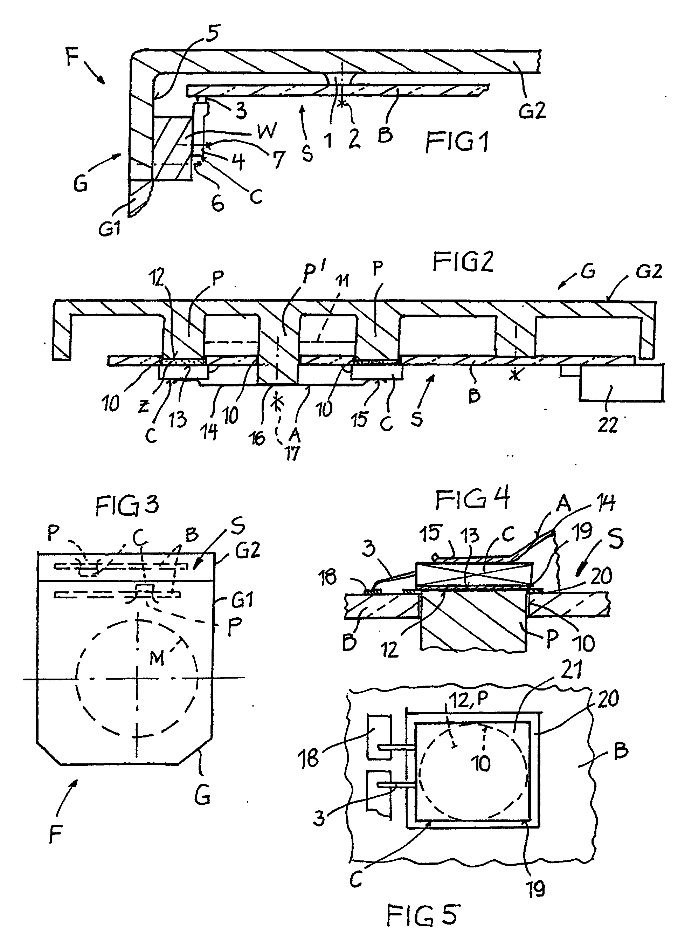

Bei Fadenliefergeräten ist es durch Vorbenutzung in der Praxis bekannt (Fig. 1), wärmeerzeugende Halbleiterkomponenten, wie Effekttransistoren, am Randbereich der Leiterplatte zu positionieren und in der Nachbarschaft der Halbleiterkomponenten einen leistenförmigen Wärmeleitkörper im Gehäuse oder an der Leiterplatte zu montieren, gegen den Teilbereiche der Halbleiterkomponenten durch Spannelemente angepreßt werden. Der Wärmeleitkörper wird seinerseits in wärmeübertragendem Kontakt mit dem Gehäuse montiert. Dies ist baulich aufwendig und erfordert im Hinblick auf die Bestückung der Leiterplatte unzweckmäßige stehende Positionen der Halbleiterkomponenten, weil diese von ihren Kontaktierungen mit der Leiterplatte hochstehen müssen, um den Wärmeleitkörper zu kontaktieren. Außerdem findet der Kontakt mit dem Wärmeleitkörper in einiger Entfernung vom wärmsten Bereich der Halbleiterkomponenten statt, der im Regelfall nahe bei den Kontaktierungen liegt und somit viel Wärme in die Umgebung abstrahlt, die nicht vom Wärmeleitkörper aufgenommen wird. Die kostengünstige, sogenannte "Oberflächenmontage", dieser Halbleiterkomponenten, z.B. durch Montageroboter, lässt sich deshalb nicht anwenden. Bei dieser zweckmäßigen Montagetechnik werden Halbleiterkomponenten liegend mit einer ihrer Oberflächen auf einer Haftfläche der Leiterplatte befestigt, und zwar entweder zusätzlich zu den Kontaktierungen oder sogar zur Herstellung einer Kontaktierung oder Erdung.

Aus EP-A-0 116 396 ist es bekannt, aufeinander stapelbare elektronische Baugruppen jeweils so zu gestalten, dass zwei aus wärmeleitendem Metall bestehende, steife Platten eine Leiterplatte mit darauf angeordneten Halbleiterkomponenten zwischen sich einklemmen. Die beiden äußeren Platten werden durch randseitige C-Klammem oder Spannschrauben gegeneinander gespannt An wenigstens einer Platte sind Vorsprünge vorgesehen, die durch Öffnungen in der Leiterplatte von unten her zu den Halbleiterkomponenten greifen. Da die Platten im wesentlichen der Größe der Leiterplatte entsprechen, haben sie nur ein begrenzte Wärmeaufnahmekapazität.

In US-A-5 812 375 mit älterem Zeitrang wird eine elektronische Baugruppe vorgeschlagen, die aus wenigstens einer mit Halbleiterkomponenten bestückten Leiterplatte und einer aus zwei Schalen bestehenden Einkapselung besteht, wobei die Basis der Einkapselung aus wärmeleitendem Material besteht und wenigstens einen Vorsprung besitzt, der in eine Öffnung der Leiterplatte bis in die Nähe einer eine zu kühlende Halbleiterkomponente tragenden Isolationsschicht ragt. Diese gekapselte Baugruppe bildet eine Einheit, in welcher die Basis der Einkapselung nur eine begrenzte Wärmeaufnahmekapazität hat.

Der Erfindung liegt die Aufgabe zugrunde, eine Fadenbearbeitungsvorrichtung der eingangs genannten Art zu schaffen, bei dem auf baulich einfache, kostengünstige Weise und platzsparend ein niedriges Temperaturniveau bei der Steuerschaltung erreichbar ist, gegebenenfalls sogar bei Anwendung der Oberflächenmontage-Technik für die Halbleiterkomponenten.

Die gestellte Aufgabe wird erfindungsgemäß mit dem Merkmal des Anspruchs 1 gelöst.

Es wird von der Halbleiterkomponente erzeugte Wärme mit gutem Wirkungsgrad durch körperliche Wärmeleitung durch die Leiterplatte hindurch in das Gehäuse bzw. den Gehäuseteil abgeführt. Der Vorsprung lässt sich einfach im Gehäuse bei dessen Formung ausbilden. Besonders zweckmäßig wird die Halbleiterkomponente in der Nähe der Kontaktierungen, d.h. nahe dem Entstehungsort der Wärme, gekühlt, weil der Fortsatz durch die Leiterplatte zum Entstehungsort greifen kann. Es wird auch ein Wärmestau zwischen der Halbleiterkomponente und der Leiterplatte vermieden, weil eine körperliche Wärmeleitstrecke von der Halbleiterkomponente in das Gehäuse geschaffen ist. Auf diese Weise lässt sich die Temperatur der Halbleiterkomponente und bei der Steuerschaltung erheblich senken, was der Betriebssicherheit und der Standzeit der Steuerschaltung zugute kommt. Das Gehäuse kann das Gehäuse des Fadenliefergeräts oder einer Zubehörvorrichtung sein, das als Gehäuse der Fadenbearbeitungsvorrichtung dank seiner Größe und Masse eine sehr große Wärmeaufnahmekapazität hat.

Herstellungstechnisch einfach sind die dem Wärmeableitkörper bildenden Fortsätze beispielsweise block- oder stiftartig und mit dem Gehäuse bzw. Gehäuseteil einstückig. Die Fortsätze lassen sich bereits bei der Formung des Gehäuses bzw. Gehäuseteils realisieren, was die spätere Montage erheblich vereinfacht (Anspruch 2). Der Durchgriff des Fortsatzes erfolgt zweckmäßig durch eine speziell dafür geformte Öffnung oder einen Ausschnitt der Leiterplatte, wobei der Fortsatz relativ passgenau oder mit einem allseitigen Spiel in die Öffnung bzw. den Ausschnitt eingreift. Bei großen Halbleiterkomponenten könnten mehrere Fortsätze gemeinsam kühlen.

Ein zwischen der Halbleiterkomponente und dem Fortsatz eingesetztes, zweckmäßigerweise zumindest etwas elastisches, Zwischenmaterial verbessert die Wärmeableitung. Ein vollflächiger Kontakt zwischen harten bzw. metallischen Oberflächen kann nämlich schwierig zu erzielen sein. Das Zwischenmaterial ist in der Lage, herstellungs- oder thermisch bedingte Fehlstellungen zwischen den wärmeableitenden Oberflächen zu kompensieren. Zweckmäßig ist das Zwischenmaterial ein elektrisch isolierendes Kissen (z.B. Gap Pad) aus gut wärmeleitendem Material, ein Klebstoff- oder Füllmittelauftrag (z.B. Silikonkunststoff) oder ein mit einem Haftmittel imprägnierter flexibler Träger (z.B. selbstklebendes Isolierband) (Anspruch 3).

Aufgrund des zur Kühlung durch die Leiterplatte zur Halbleiterkomponente greifenden Fortsatzes (mit oder ohne Zwischenmaterial), lässt sich die zu kühlende Halbleiterkomponente günstig nach der sogenannten Oberflächenmontage-Technik auf der Leiterplatte anbringen, d.h. in einer automatischen Montagevorrichtung und/oder mit Montagerobotern (Anspruch 4).

Günstig wird die Halbleiterkomponente an der dem Fortsatz gegenüberliegenden Seite von einem Widerlager beaufschlagt. Dies ist aus unterschiedlichen Gründen vorteilhaft (Anspruch 5). Das Widerlager kann kraftschlüssig mit dem gegen die Halbleiterkomponente drückenden Fortsatz ein Kraftgleichgewicht erzeugen, so dass der Verbindungsbereich der Halbleiterkomponente mit der Leiterplatte bzw. die Kontaktierungen keinen unerwünschten Belastungen unterliegen. Ferner lässt sich mittels des Widerlagers der Kontaktdruck zwischen dem Fortsatz und der Halbleiterkomponente einstellen. Schließlich ist mittels des Widerlagers gleich auch die Leiterplatte im Gehäuse oder einem Gehäuseteil positionier- und lagersicherbar, so dass die Anzahl der Befestigungsstellen für die Leiterplatte verringert werden kann oder überhaupt keine weitere Befestigungsstellen mehr notwendig sind. Das Widerlager kann ein formschlüssiges Positionierglied für die Halbleiterkomponente sein.

Das Widerlager kann ein Federelement aufweisen (Anspruch 6), vorzugsweise mit einstellbarer Andruckkraft, um das vorerwähnte Kraftgleichgewicht und auch die Lagesicherung der Leiterplatte vornehmen zu können. Beispielsweise wird das Federelement gegen seinen Halteblock auf Anschlag festgelegt, so dass die Niederhaltekraft genau vorherbestimmbar ist.

Montagetechnisch günstig ist mehreren Halbleiterkomponenten ein gemeinsames Widerlager zugeordnet (Anspruch 7).

Wie erwähnt, definieren die Fortsätze mit dem Widerlager einen Leiterplatten-Haltevorrichtung, so dass weitere Befestigungsstellen und Montageschritte beim Festlegen der Leiterplatte entbehrlich sind, sobald die Montageschritte zur Kühlung vollzogen sind (Anspruch 8).

Im Hinblick auf einen guten Wärmeübergang bei der Wärmeableitung sollten die Endflächen der Fortsätze spanabhebend bearbeitet sein (Anspruch 9). Gegebenenfalls sind die Endflächen sogar an die Konturen der Halbleiterkomponenten im Auflagebereich angepasst.

Mehrere, zur Kühlung dienende Fortsätze des Gehäuses könnten durch Verbindungsstege untereinander verbunden oder in einem gemeinsamen Sockel enthalten sein (Anspruch 10), um auf kurzem Weg eine möglichst große Masse zur Kühlung bzw. Wärmeverteilung nutzen zu können.

Wenn an wenigstens einem der Fortsätze eine Auftageschulter für die Leiterplatte vorgesehen ist (Anspruch 11), wird die Positionierung und Lagesicherung der Leiterplatte vereinfacht.

Anhand der Zeichnung wird eine konventionelle Ausführungsform und werden Ausführungsformen des Erfindungsgegenstandes erläutert. Es zeigen:
- Fig. 1: einen Teilschnitt einer konventionellen Kühtstruktur (Stand der Technik),
- Fig. 2: einen Schnitt durch eine erfindungsgemäße Ausführungsform einer Kühlstruktur für eine Fadenbearbeitungsvorrichtung, z.B. für ein Fadenliefergerät,
- Fig. 3: eine schematische Frontansicht des Fadenliefergeräts,
- Fig. 4: einen vergrößerten Detailschnitt der erfindungsgemäßen Ausführungsform einer Kühlstruktur, und
- Fig. 5: eine Draufsicht zu Fig. 4.

Fig. 1 verdeutlicht eine konventionelle Kühlstruktur für ein Fadenbearbeitungssystem F, wie sie in auf dem Markt befindlichen Fadenliefergeräten F anzutreffen ist. Das Fadenliefergerät F besitzt ein Gehäuse G aus metallischem Material (Leichtmetall, Leichtmetallegierung, Druckguß, Zinkdruckguß oder dgl.), das z.B. aus einem Grundgehäuse G1 und einem abdeckenden Gehäuseteil G2 zusammengesetzt ist. Eine zumindest mit Halbleiterkomponenten C (Effekttransistoren, Prozessoren oder dgl.) bestückte Leiterplatte B ist an Lagern 1 des Gehäuseteils G2 mit Befestigungselementen 2 festgelegt. Die Halbleiterkomponenten C sind nahe dem Randbereich der Leiterplatte B mit Kontaktierungen 3 angeschlossen, dabei aber so montiert, daß sie mit ihren Körpern 4 von der Leiterplatte B hochstehen. An der Innenseite des Gehäuseteils G2 ist ein leistenförmiger Wärmeübertragungskörper W, z.B. aus Metall, mit Befestigungselementen 6 festgelegt, so daß zwischen dem Wärmeleitkörper W und dem Gehäuseteil G2 eine körperliche Wärmeableitung stattfindet. Die Körper 4 der Halbleiterkomponenten C sind mit Befestigungselementen 7 kontaktierend gegen den Wärmeleitkörper W gespannt, um auftretende Wärme in den Wärmeleitkörper W zu übertragen.

Fig. 2 verdeutlicht einen Schnitt durch eine erfindungsgemäße Kühlstruktur für Halbleiterkomponenten C (Effekttransistoren, Prozessoren oder dgl.) einer Steuerschaltung 5 eines Fadenliefergeräts F eines Fadenbearbeitungssystems. Die mit den Halbleiterkomponenten C bestückte Leiterplatte B ist an dem Gehäuseteil G2 des Gehäuses G montiert. Die Steuerschaltung S könnte auch in einem vom Fadenbearbeitungsgerät getrennten, mit dieser Kühlstruktur ausgestatteten Gehäuse angeordnet sein.

Jede Halbleiterkomponente C ist über ihre Kontaktierungen 3 mit nicht dargestellten Leiterbahnen der Leiterplatte B verbunden und liegt mit einer (13) ihrer Oberflächen benachbart zur Leiterplatte W oder an dieser. Im Bereich der Halbleiterkomponente C ist die Leiterplatte B mit einer durchgehenden Öffnung 10 versehen (oder mit einem zum Randbereich offenen Ausschnitt, nicht gezeigt), in die ein mit dem Gehäuseteil G2 einstückig ausgebildeter Fortsatz P (z.B. in Stift-, Block-, Kegelstumpf- oder Pyramidenstumpf-Form) derart eingreift, daß seine Endfläche 12 die Oberfläche 13 der Halbleiterkomponente C direkt kontaktiert, oder wie gezeigt, unter Vermittlung eines gut wärmeleitenden Zwischenmaterials Z. Das Zwischenmaterial Z ist beispielsweise ein elektrisch isolierendes, gut wärmeleitendes Kissen (z.B. ein Gap Pad), oder ein Klebstoff- oder Füllmittelauftrag oder ein mit einem Haftmittel imprägnierter, elastischer Träger. Das Zwischenmaterial Z kann eine gewisse Elastizität und zweckmäßigerweise Hafteigenschaften zu beiden Oberflächen 12, 13 aufweisen, um den Wärmeübergang zu verbessern. Es ist jedoch auch durchaus möglich, die Endfläche 12 direkt an die Endfläche 13 anzulegen, beispielsweise falls durch eine Bearbeitung der Endfläche 12 und eine dazu passende Oberfläche 13 der Halbleiterkomponente C ein vollflächiger Kontakt sicherstellbar ist, und gegebenenfalls durch diesen Kontakt eine Erdung oder Kontaktierung hergestellt werden soll.

In den Gehäuseteil G2 sind ferner Halte-Fortsätze P' integriert. Einer der Halte-Fortsätze P' dient zum Festlegen eines Widerlagers A, das die Halbleiterkomponenten C entgegengesetzt zum Kontaktdruck der Fortsätze P form- und/oder kraftschlüssig beaufschlagt. Das Widerlager A kann ein Federelement 14 sein, das mit mehreren Endbereichen 15 gemeinsam mehrere Halbleiterkomponenten C beaufschlagt und in einem Befestigungsbereich 16 mittels eines Befestigungselementes 17 an dem Fortsatz P' festgelegt ist. Die elastische Andruckkraft jedes Endbereiches 15 ist einstellbar, beispielsweise durch Spannen des Befestigungsbereiches 16 auf Anschlag mit dem Halte-Fortsatz P'. Auch der Halte-Fortsatz P' durchsetzt eine Öffnung der Leiterplatte B. Das Widerlager A kann auch ein formschlüssiger Positionieranschlag für eine oder mehrere Halbleiterkomponenten D sein.

Ein weiterer Haltevorsprung P' des Gehäuseteils G2 kann zusätzlich zum Festlegen der Leiterplatte B genutzt werden, beispielsweise in der Nähe eines Anschlußkörpers 22, vor allem deshalb, weil beim Benutzen des Anschlußkörpers 22 (Anschließen oder Lösen einer elektrischen Verbindung) Kräfte in die Leiterplatte B eingeleitet werden können, die dann der Halte-Fortsatz P' aufnimmt.

Die Fortsätze P, zumindest ein Halte-Fortsatz P', und das Widerlager A können gemeinsam eine Montier-Vorrichtung für die Leiterplatte B definieren, so daß keine weiteren Befestigungseinrichtungen mehr benötigt werden, sondern die Leiterplatte B ordnungsgemäß lagegesichert ist, sobald die baulichen Voraussetzungen für die Kühlung der Halbleiterkomponenten C geschaffen wurden.

In Fig. 3 ist angedeutet, daß die Leiterplatte B entweder im Gehäuseteil G2 oder im Gehäuseteil G1 montiert sein kann. Die Halbleiterkomponenten C können an der Leiterplatte B im Gehäuseteil G2 zum Gehäuseteil G1 weisen, und an der Leiterplatte B im Gehäuseteil G1 zum Gehäuseteil G2 weisen. Die Fortsätze P greifen zur Kühlung jeweils durch die Leiterplatte B. In Fig. 3 ist auch der im Gehäuseteil G1 enthaltene Motor M gestrichelt angedeutet, der über die an der Leiterplatte B angeordnete Steuerschaltung gesteuert wird. Die jeweilige Leiterplatte B könnten auch hochkant oder schrägstehend im Gehäuse G angeordnet sein. Auch dann greift jeweils mindestens ein Fortsatz durch die Leiterplatte zur zu kühlenden Halbleiterkomponente. Ist die Steuerschaltung S (nicht gezeigt) in einem eigenen Gehäuse enthalten, dann ist die Kühlstruktur in dieses Gehäuse integriert.

In Fig. 2 ist angedeutet, daß die Halbleiterkomponenten C nach der sogenannten "Oberflächenmontage-Technik" an der Leiterplatte B montiert sind. Die Fig. 4 und 5 verdeutlichen eine Variante dieser Montagetechnik, die in weitgehend automatisierten oder mit Robotern ausgestatteten Montagevorrichtungen kostengünstig anwendbar ist.

In den Fig. 4 und 5 ist auf der Leiterplatte B ein flächiger Haftbereich 20 (aus Metall) angebracht, der entweder nur für eine Haftfunktion der Halbleiterkomponente C benötigt wird, oder auch zum Herstellen einer Kontaktierung (z.B. Erdung oder einer anderen Kontaktierung gleichwertig der Kontaktierung 13 mit der Leiterbahn 18). Die Halbleiterkomponente C weist auf ihrer Oberfläche 13 eine metallische Schicht 19 auf, die zum Festlegen der Halbleiterkomponente C an der Leiterplatte B (zusätzlich zur Kontaktierung 3) mit dem Haftbereich 20 verbunden wird, wenn die Leiterplatte B bestückt wird. Eine weitere Befestigung der Halbleiterkomponente C ist dann nicht mehr erforderlich.

Die Öffnung 10 durch die Leiterplatte B, die für den Eingriff des Fortsatzes P als Wärmeleitkörper W bestimmt ist, erstreckt sich entweder bis zum Haftbereich 20, oder aus herstellungstechnischen Gründen durch den Haftbereich 20 hindurch, so daß dann die Endfläche 12 des Fortsatzes P direkt an der Metallschicht 19 anliegt, um Wärme abzuleiten. Gegebenenfalls ist ein in Fig. 2 gezeigtes Zwischenmaterial Z zwischen der Endfläche 12 und der Metallschicht 19 an der Oberfläche 13 vorgesehen, um den Wärmeübergang zu verbessern. Das Widerlager A liegt mit seinem Endbereich 25 auf der dem Fortsatz P abgewandten Oberseite der Halbleiterkomponente C.

In Fig. 5 erstreckt sich der Haftbereich 20 über die z.B. viereckige Außenkontur der Halbleiterkomponente C nach außen. Da die Öffnung 10 eine runde Bohrung ist, und auch der Fortsatz P eine runde Endfläche hat ergeben sich in Eckbereichen 21 genügend große Flächen zum Anhaften der Halbleiterkomponente C im Haftbereich 20 (Surface Mounting), und wird dennoch wirksam nahe der Oberfläche 13 in der Halbleiterkomponente C entstehende Wärme durch die Leiterplatte B hindurch abgeführt.

## Patentansprüche

1. Fadenbearbeitungsvorrichtung, insbesondere Fadenliefergerät (F), mit einem aus wärmeleitendem Material bestehenden Gehäuse (G, G1, G2), in welchem auf einer Leiterplatte (B) einer Steuerschaltung (S) wenigstens eine im Betrieb Wärme erzeugende Halbleiterkomponente (C) mit Kontaktierungen (3) angeordnet ist und Wärme an wenigstens einen mit dem die Steuerung aufnehmenden Gehäuse (G) in Verbindung stehenden Wärmeleitkörper (W) abgibt, **dadurch gekennzeichnet, dass** sich der Wärmeleitkörper (W) ausgehend von dem Gehäuse (G, G1) oder einem Gehäuseteil (G2) der Fadenbearbeitungsvorrichtung durch eine in der Leiterplatte (B) durchgehend geformte Öffnung (10) und durch die Leiterplatte (B) hindurch bis zur Halbleiterkomponente (C) erstreckt.

2. Fadenbearbeitungsvorrichtung nach Anspruch 1, **dadurch gekennzeichnet, dass** der Wärmeleitkörper (W) wenigstens ein mit dem Gehäuse (G, G1) bzw. dem Gehäuseteil (G2) der Fadenbearbeitungsvorrichtung, insbesondere eines Fadenliefergeräts (F), einstückiger Fortsatz (P, P') ist.

3. Fadenbearbeitungsvorrichtung nach Anspruch 2, **dadurch gekennzeichnet, dass** zwischen der Halbleiterkomponente (C) und dem Fortsatz (P) wärmeleitendes Zwischenmaterial (Z) angeordnet ist, das mit dem Fortsatz (P) und der Halbleiterkomponente (C) in Oberflächenkontakt steht, vorzugsweise ein elektrisch isolierendes Kissen, ein Klebstoff- oder Füllmittelauftrag, oder ein mit einem Haftmittel imprägnierter flexibler Träger.

4. Fadenbearbeitungsvorrichtung nach Anspruch 2, **dadurch gekennzeichnet, dass** die Halbleiterkomponente (C) mit einer ihrer Oberflächen (13) an einem an der Leiterplatte (B) vorgesehenen Haftbereich (20) nach der Surface-Mounting-Methode montiert ist, und dass sich der Fortsatz (P) durch die Leiterplatte (B) bis zum Haftbereich (20) oder durch den Haftbereich (20) zur Oberfläche (13, 19) der Halbleiterkomponente (C) erstreckt.

5. Fadenbearbeitungsvorrichtung nach Anspruch 2, **dadurch gekennzeichnet, dass** die Halbleiterkomponente (C) an der dem Fortsatz (P) gegenüberliegenden Seite von einem Widerlager (A) kraft- und/oder formschlüssig beaufschlagt ist, das an einem, vorzugsweise von einer Seite zur anderen Seite durch die Leiterplatte (B) hindurchgreifenden, Haltefortsatz (P') des Gehäuses (G, G1) bzw. des Gehäuseteils (G2) der Fadenbearbeitungsvorrichtung angeordnet ist.

6. Fadenbearbeitungsvorrichtung nach Anspruch 5, **dadurch gekennzeichnet, dass** das Widerlager (A) ein Federelement (14) mit einstellbarer Andruckkraft oder ein formschlüssiges Positionierelement aufweist.

7. Fadenbearbeitungsvorrichtung nach wenigstens einem der vorhergehenden Ansprüche, **dadurch gekennzeichnet, dass** mehreren Halbleiterkomponenten (C) an der Leiterplatte (B) ein gemeinsames Widerlager (A) zugeordnet ist.

8. Fadenbearbeitungsvorrichtung nach wenigstens einem der vorhergehenden Ansprüche, **dadurch gekennzeichnet, dass** die Leiterplatte (B) mittels einer Leiterplatten-Haltevorrichtung lagegesichert ist, die von wenigstens einem Fortsatz (P, P') und dem Widerlager (A) des Gehäuses der Fadenbearbeitungsvorrichtung gemeinsam gebildet wird.

9. Fadenbearbeitungsvorrichtung nach wenigstens einem der vorhergehenden Ansprüche, **dadurch gekennzeichnet, dass** die Fortsätze (P) spanabhebend bearbeitete Endflächen (12) aufweisen.

10. Fadenbearbeitungsvorrichtung nach wenigstens einem der vorhergehenden Ansprüche, **dadurch gekennzeichnet, dass** mehrere Fortsätze (P, P') durch Verbindungsstege (11) untereinander verbunden oder in einen gemeinsamen Sockel (11) integriert sind.

11. Fadenbearbeitungsvorrichtung nach wenigstens einem der vorhergehenden Ansprüche, **dadurch gekennzeichnet, dass** wenigstens einer der Fortsätze (P, P') eine Auflageschulter für die Leiterplatte (B) aufweist.

## Claims

1. A yarn processing device, in particular a yarn feeder (F), comprising a housing (G, G1, G2) consisting of heat-conducting material, in which on a printed circuit board (B) of a control circuit (S) of a control unit at least one semiconductor component (C) that generates heat during operation is arranged with bondings (3) and transfers heat to at least one heat conducting body (W) connected with said housing (G) receiving the control unit, **characterized in that** said heat conducting body (W) extends, starting from said housing (G, G1) or a housing part (G2) of said yarn processing device, through an opening (10) penetratingly formed in said printed circuit board (B), and through said printed circuit board (B) up to said semiconductor component (C).

2. The yarn processing device according to claim 1, **characterized in that** said heat conducting body (W) is at least one integral prolongation (P, P') of said housing (G, G1) or said housing part (G2) of said yarn processing device, in particular of a yarn feeder (F).

3. The yarn processing device according to claim 2, **characterized in that** heat-conducting intermediate material (Z) is arranged between said semiconductor component (C) and said prolongation (P) and is in surface contact with said prolongation (P) and said semiconductor component (C), preferably an electrically insulating pad, an adhesive or filler overlay, or a flexible carrier impregnated with an adhesive agent.

4. The yarn processing device according to claim 2, **characterized in that** said semiconductor component (C) is mounted according to the surface mounting method with one of its surfaces (13) on an adhesive portion (20) provided on said printed circuit board (B), and that said prolongation (P) extends through said printed circuit board (B) to said adhesive portion (20) or through said adhesive portion (20) to the surface (13, 19) of said semiconductor component (C).

5. The yarn processing device according to claim 2, **characterized in that** said semiconductor component (C) is acted upon in a non-positive and/or positive manner by an abutment (A) at the side opposite to said prolongation (P), said abutment being arranged on a holding prolongation (P') of said housing (G, G1) or housing part (G2) of said yarn processing device, which holding prolongation extends through said printed circuit board (B) from its one side to its other one.

6. The yarn processing device according to claim 5, **characterized in that** said abutment (A) is a spring element (14) with an adjustable contact pressure, or a positive positioning element.

7. The yarn processing device according to at least one of the preceding claims; **characterized in that** a plurality of semiconductor components (C) on said printed circuit board (B) have assigned thereto a joint abutment (A).

8. The yarn processing device according to at least one of the preceding claims, **characterized in that** said printed circuit board (B) is secured in its position by means of a holding device for printed circuit boards that is jointly formed by at least one prolongation (P, P') and said abutment (A) of said housing of said yarn processing device.

9. The yarn processing device according to at least one of the preceding claims, **characterized in that** said prolongations (P) comprise machined end faces (12).

10. The yarn processing device according to at least one of the preceding claims, **characterized in that** a plurality of prolongations (P, P')) are interconnected by connection webs (11) or are integrated into a joint base (11).

11. The yarn processing device according to at least one of the preceding claims, **characterized in that** at least one of said prolongations (P, P') comprises a support shoulder for said printed circuit board (B).

## Revendications

1. Système de traitement de fil, en particulier appareil d'alimentation en fil (F), comportant un boîtier (G, G1, G2) constitué de matériau thermoconducteur dans lequel, sur une carte de circuits imprimés (B) d'un circuit de commande (S), au moins un composant à semi-conducteurs (C) comportant des contacts (3) et produisant de la chaleur durant le fonctionnement est disposé et cède de la chaleur à au moins un corps thermoconducteur (W) relié au boîtier (G) logeant la commande, **caractérisé en ce que** le corps thermoconducteur (W) s'étend en partant du boîtier (G, G1) ou d'une partie (G2) du boîtier du système de traitement de fil à travers une ouverture (10) formée de bout en bout dans la carte de circuits imprimés (B) et à travers la carte de circuits imprimés (B) jusqu'au composant à semi-conducteurs (C).

2. Système de traitement de fil selon la revendication 1, **caractérisé en ce que** le corps thermoconducteur (W) est au moins un prolongement monobloc (P, P') avec le boîtier (G, G1) ou la partie (G2) du boîtier du système de traitement de fil, en particulier d'un appareil d'alimentation en fil.

3. Système de traitement de fil selon la revendication 2, **caractérisé en ce qu'**entre le composant à semi-conducteurs (C) et le prolongement (P) est disposé un matériau intermédiaire (Z) thermoconducteur qui est en contact superficiel avec le prolongement (P) et le composant à semi-conducteurs (C), de préférence un coussin électriquement isolant, une application de colle ou de matière de remplissage, ou un support flexible imprégné d'un agent adhésif.

4. Système de traitement de fil selon la revendication 2, **caractérisé en ce que** le composant à semi-conducteurs (C) est monté par une de ses surfaces (13) sur une zone d'adhérence (20) prévue sur la carte de circuits imprimés (B), par la méthode du montage en surface, et **en ce que** le prolongement (P) s'étend à travers la carte de circuits imprimés (B) jusqu'à la zone d'adhérence (20) ou à travers la zone d'adhérence (20) jusqu'à la surface (13, 19) du composant à semi-conducteurs (C).

5. Système de traitement de fil selon la revendication 2, **caractérisé en ce que** le composant à semi-conducteurs (C) est, sur la face opposée au prolongement (P), sollicité par adhérence et/ou engagement positif par une butée qui est disposée sur un prolongement de retenue (P'), allant de préférence d'une face à l'autre à travers la carte de circuits imprimés (B), du boîtier (G, G1) ou de la partie (G2) du boîtier du système de traitement de fil.

6. Système de traitement de fil selon la revendication 5, **caractérisé en ce que** la butée (A) présente un élément élastique (14) à force de pression réglable ou un élément de positionnement à engagement positif.

7. Système de traitement de fil selon au moins l'une des revendications précédentes, **caractérisé en ce qu'**une butée (A) commune est associée à plusieurs composants à semi-conducteurs (C) sur la carte de circuits imprimés (B).

8. Système de traitement de fil selon au moins l'une des revendications précédentes, **caractérisé en ce que** la carte de circuits imprimés (B) est fixée en position par un dispositif de retenue de la carte de circuits imprimés qui est constitué par au moins un prolongement (P, P') et la butée (A) du boîtier du système de traitement de fil.

9. Système de traitement de fil selon au moins l'une des revendications précédentes, **caractérisé en ce que** les prolongements (P) présentent des surfaces d'extrémité (12) usinées par enlèvement de copeaux.

10. Système de traitement de fil selon au moins l'une des revendications précédentes, **caractérisé en ce que** plusieurs prolongements (P, P') sont reliés les uns aux autres par des nervures de liaison (11) ou intégrés dans un socle commun (11).

11. Système de traitement de fil selon au moins l'une des revendications précédentes, **caractérisé en ce qu'**au moins un des prolongements (P, P') présente un épaulement d'appui pour la carte de circuits imprimés (B).
